# EUROPEAN PATENT APPLICATION

(11) **EP 4 064 506 A1**
(43) Date of publication of application: **28.09.2022**
(21) Application number: 21164505.6
(22) Date of filing: 24.03.2021
(51) Int. Cl.: H02J 7/00

(54) **BATTERY SYSTEM AND BATTERY MANAGEMENT METHOD**

(71) Applicant: CSEM Centre Suisse d'Electronique et de Microtechnique SA - Recherche et Développement, 2002 Neuchâtel (CH)
(72) Inventor: NAMOR, Emil, 1022 Chavannes-Près-Renens (CH); BRIVIO, Claudio, 2000 Neuchâtel (CH); LE ROUX, Erwan, 2000 Neuchâtel (CH)
(74) Representative: e-Patent SA

(57) **Abstract**

Battery system (1) comprising a plurality of rechargeable cells (3) connectable in series along a power line (7), each cell (3) being packaged with:
- a corresponding controller (5);
- a corresponding memory (25);
- a corresponding communications interface (27);
wherein each cell (3) is arranged to be by passable under the control of said corresponding controller (5), said corresponding controller (5) being adapted to:
- bypass the corresponding cell (3) by means of a corresponding bypass circuit (9);
- carry out diagnostics on said corresponding cell (3) when bypassed, under the power of said corresponding cell (3);
- communicate with at least one other controller (5; 33) by means of said corresponding communications interface (27), and
- store information relating to said diagnostics in said corresponding memory (25).

## Description

### Technical Field

The present invention relates to the field of battery systems. In particular, it relates to a battery system and a method of management thereof.

### State of the art

US2014/117938 describes a battery system and a battery management method, in which the charge of cells can be balanced by means of a switching matrix. The individual cells can be charged and/or discharged by controlling this switching matrix, and a diagnostic system is connected to the switching matrix in such a way as to be able to carry out diagnostics on the individual cells, so as to determine their state of charge and/or state of health via an electrochemical impedance spectroscopy (EIS) method.

This approach uses a single diagnostic system for a number of cells, which requires a significant amount of extra external electrical connections, and does not enable easy traceability of the cells once a given battery system is dismantled. Repurposing the cells for so-called second-life applications is thus hindered.

An aim of the present invention is hence to at least partially overcome the above-mentioned drawbacks of the prior art.

### Disclosure of the invention

More particularly, the invention relates to a battery system as defined in claim 1. This battery system comprises a plurality of rechargeable cells connectable in series along a power line as a string, each cell being packaged with, e.g. in a self-contained cell module:
- a corresponding controller, which is hence local to each cell;
- a corresponding memory;
- a corresponding communications interface;
wherein each corresponding cell is arranged to be bypassable under the control of said controller, said controller being adapted to:
- electrically bypass the corresponding cell by means of a corresponding bypass circuit, i.e. to remove it from the power line;
- carry out diagnostics on said cell when bypassed, under the power of said cell (rather than by external power), e.g. by means of electrochemical impendence spectroscopy, differential voltage analysis method, or a galvanostatic intermittent titration technique, e.g. so as to estimate the state of charge, state of health, state of power etc. of the cells;
- communicate with at least one other controller by means of said corresponding communications interface, this controller being either one or more controllers packaged with individual cells in the same string or an external controller not associated with an individual cell, and
- store information relating to said diagnostics in said corresponding memory.

As a result, each individual cell's memory, which is packaged with it, contains a record of the cell's life and/or data relating to its current condition, which hence travels with the cell when the battery system is broken up. This is highly useful for second-life applications, such as repurposing cells from an electric vehicle battery into a static storage system for a photovoltaic system, since this information remains packaged with each individual cell and is hence accessible irrespective of what happens to the overall battery system.

Furthermore, the results of diagnostics such as state of health and/or state of charge and/or state of power of the cells can be monitored individually (as opposed to collectively) at relatively frequent intervals (which is hence very accurate and carried out on a cell-by-cell level), and the durations for which each cell is bypassed can be varied in order to optimize the state of health and/or state of charge and/or state of power of the cells in the string. As an example, short term it is advantageous that all the cells in a string have a similar state of charge and/or power, and as a result cells which are relatively undercharged can be bypassed for longer, in order to draw more current from cells with higher states of charge. Longer term, since the overall performance of a string of cells is determined by its weakest cell, the weaker cells can be bypassed for relatively longer periods, causing the stronger cells to work harder and hence deteriorate faster, such that the deterioration of the individual cells in a string is as equal as possible. The overall lifetime and performance of the battery system can hence be optimized by modulating the bypass durations of each cell.

Several options are possible for coordinating the operation of the controllers to bypass cells, carry out diagnostics etc. Firstly, the battery system may comprise a central controller adapted to coordinate the operation of said corresponding controllers, the central controller being in communication with the controllers packaged with each individual cell. Alternatively, one controller packaged with a cell in said battery system can act as master controller to coordinate the operation of said corresponding controllers, or a number of the controllers packaged with individual cells can be arranged to coordinate operation by distributed processing.

Advantageously, said corresponding communications interface is adapted to communicate with said at least one other controller via at least one of:
- powerline communication;
- infrared communication;
- wireless communication.

No extra wiring is hence required, since either the powerline itself is used, or wireless communication is used. This significantly simplifies the architecture of the battery system.

Advantageously, said bypass circuit comprises a first transistor and a second transistor (e.g. a P-type and N-type MOSFET) arranged to direct current from a first connection terminal to said corresponding cell or to a second connection terminal under the control of said corresponding controller depending on an output of said corresponding controller.

Advantageously, said bypass circuit further comprises a switching circuit arranged such that, when said output of said corresponding controller changes state, said transistor which is in a conducting state is switched to a non-conducting state prior to the transistor which is in a non-conducting state being switched to a conducting state. All risk of the bypass circuit causing a cell to be short circuited can hence be avoided. Various switching circuits are known to the skilled person and need not be hence defined explicitly here.

Advantageously, the battery system further comprises a drain transistor in series with a resistor so as to form a circuit with said corresponding cell, said transistor being controllable by said corresponding controller so as to drain current from said corresponding cell in order to carry out diagnostics thereupon. This current can be modulated at one or several frequencies, in order to carry out electrochemical impedance spectroscopy or other diagnostics such as are known to the skilled person and hence need not be defined explicitly here. The same drain transistor can also be used for actively dissipating excess charge through the corresponding resistor.

Advantageously, each controller is arranged to measure a voltage across its corresponding cell, which is advantageous for carrying out electrochemical impedance spectroscopy, a differential voltage analysis method, differential thermal voltammetry, or a galvanostatic intermittent titration technique.

Advantageously, the battery system further comprises at least one sensor arranged to measure a parameter of said corresponding cell such as its temperature or pressure. This provides further information regarding the state of each individual cell.

The invention furthermore relates to a method of operation of a battery system as defined above, the method comprising steps of:
- bypassing at least one predetermined cell;
- carrying out diagnostics on said predetermined cell by means of its corresponding controller;
- storing information relating to said diagnostics in said corresponding controller;
- communicating said information relating to said diagnostics to at least one other controller;
- coordinating said cell bypassing to optimise battery system lifetime and/or charge balancing between said cells.

As a result, each individual cell's memory, which is packaged with it, contains a record of the cell's life and/or data relating to its current condition, which hence travels with the cell when the battery system is broken up. This is highly useful for second-life applications, such as repurposing cells from an electric vehicle battery into a static storage system for a photovoltaic system, since this information remains packaged with each individual cell and is hence accessible irrespective of what happens to the overall battery system.

Furthermore, the state of health and/or state of charge and/or state of power of the cells can be monitored individually (as opposed to collectively) at relatively short intervals, and the durations for which each cell is bypassed can be varied in order to optimize the state of health and/or state of charge and/or state of power of the cells in the string. As an example, short term it is advantageous that all the cells in a string have a similar state of charge and/or power, and as a result cells which are relatively undercharged can be bypassed for longer, in order to draw more current from cells with higher states of charge. Longer term, since the overall performance of a string of cells is determined by its weakest cell, the weaker cells can be bypassed for relatively longer periods, causing the stronger cells to work harder and hence deteriorate faster, such that the deterioration of the individual cells in a string is as equal as possible. The overall lifetime and performance of the battery system can hence be optimized by modulating the bypass durations of each cell.

Advantageously, said diagnostics are carried out at least partially by means of an electrochemical impedance spectroscopy method, particularly by means of controlling a drain transistor in series with a resistor in order to drain current from said predetermined cell following a current profile (e.g. a sinusoid, square wave, triangular wave or similar) with at least one predetermined frequency while measuring a voltage across said corresponding cell.

The coordination of the controllers can be carried out by means of one of:
- a central controller;
- a controller corresponding to a given cell;
- by a plurality of said controllers corresponding to said cells, by distributed processing.

Advantageously, if a particular cell is determined as having an excessively high state of charge, a corresponding drain transistor can be controlled by the corresponding controller in order to forcibly reduce its state of charge, by dissipating current in the corresponding resistor with which the drain transistor in question is in series.

### Brief description of the drawings

Further details of the invention will become clear upon reading the detailed description, in connection with the annexed figures which illustrate:
- Figure 1: a schematic diagram of part of a battery system according to the invention; and
- Figure 2: a circuit diagram of a switching circuit which can be incorporated in the battery system according to the invention.

### Embodiments of the invention

In the following description, elements with suffixes a, b, c (e.g. 3a, 3b, 3c) are collectively described by their numeral alone (e.g. 3), and individually described in by the numeral with the corresponding suffix (e.g. 3a, 3b, 3c).

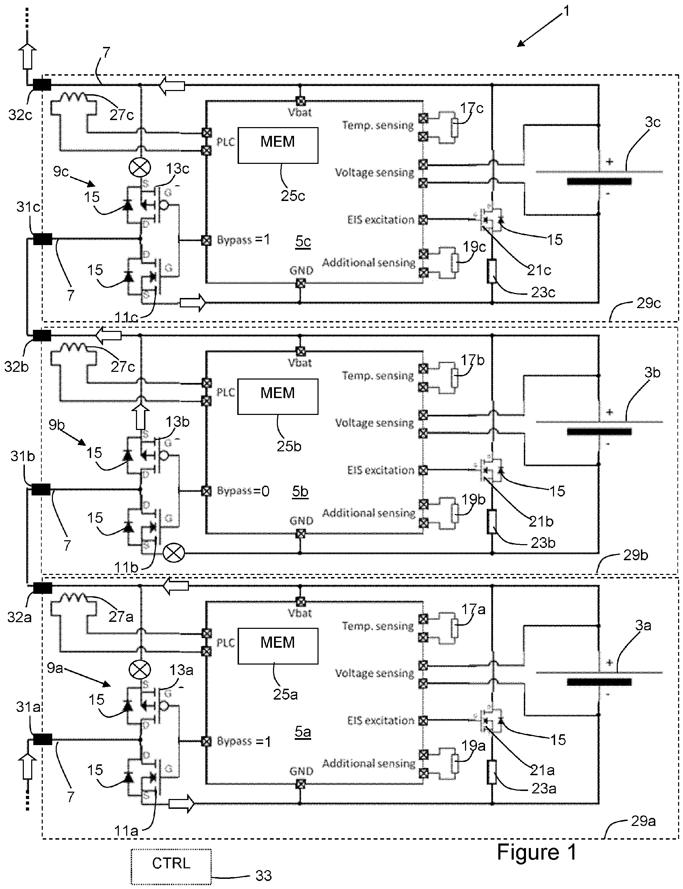

Figure 1 illustrates schematically a section of a battery system 1 according to the invention, in which three rechargeable cells 3a, 3b, 3c are connectable in series in a string and are each bypassable under the control of a corresponding controller 5a, 5b, 5c, which is local to each respective cell 3. The number of cells 3 which are arranged in a single string varies depending on the type of cell technology used, which determines the voltage of each cell, and the nominal output voltage that each string is to provide. A number of such strings can be arranged in parallel and/or in series, and the entire battery system may hence contain hundreds or even thousands of cells 3. Furthermore, each cell 3 may be comprised of a number of subcells arranged electrically in parallel and packaged together, as is generally known.

In the present invention, each string of cells 3 contains more cells than required for the overall output voltage desired, as will become clear below. For instance, in the case of lithium-ion cells, the nominal rated cell voltage is 3.6V, and hence for a total output voltage for the string of 36V, a minimum of 11 cells 3 per string is required, such that one cell 3 is bypassed at any given time. In the case in which two cells 3 are bypassed at any given time, the number of cells would be 12

As illustrated by the arrows indicating the direction of the flow of current and the X-in-circle symbols illustrating sections of power line 7 which are blocked to current, cells 3a and 3c are arranged in series, and cell 3b is bypassed.

In order to control which cells 3 are connected in series and which are bypassed, each cell 3 is associated with a corresponding controller 5, which is powered by the corresponding cell itself (as can be clearly seen from the circuit diagram) rather than by an external source of power. Bypassing is achieved by means of a bypass circuit 9.

Each bypass circuit 9 in the illustrated embodiment comprises a corresponding first transistor 11a, 11b, 11c, here an N-type MOSFET, arranged to selectively connect the incoming power line 7 to the negative terminal of the corresponding cell 3a, 3b, 3c, and a corresponding second transistor 13a, 13b, 13c, here a P-type MOSFET, arranged to selectively connect the incoming power line 7 to the positive side of the corresponding cell 3a, 3b, 3c, and thereby bypass it. It should be noted that although MOSFETs are illustrated in figure 1, other types of transistor are equivalent and can also be used, as is generally known.

The gates of the two MOSFETs 11, 13 of each pair are connected in parallel to an output labelled "bypass" of the corresponding controller 5, and when the output voltage of "bypass" is high (i.e. "1", corresponding to the cell voltage), the N-type MOSFET 11 conducts whereas the P-type MOSFET 13 does not, thereby connecting the corresponding cell 3 into the powerline 7. This is the case for the lower and upper cells 3a, 3c in figure 1, which are hence connected in series.

On the other hand, when the output "bypass" is low (i.e. "0", corresponding to ground), the N-type MOSFET 11 does not conduct, whereas the P-type MOSFET 13 conducts, bypassing the corresponding cell 3 and eliminating it from the power line 7. This is the case for middle cell 3b in figure 1, which is bypassed.

Since the N-type MOSFETs 11 are upstream of the negative power connection GND of the controllers 5, these latter remain connected to the corresponding cell 3. Likewise, the P-type MOSFETs 13 are arranged such that they do not influence the positive power connection Vbat of the corresponding controller 3, which remains in direct electrical connection with the positive terminal of the corresponding cell 3. As a result, each controller 5 - cell 3 pair remains autonomous and self-powering.

The drain and source of each MOSFET 11, 13 are connected by a corresponding reverse-biased diode 15, arranged so as to bypass the corresponding MOSFET in the case of a fast reverse-polarity transient or a system fault causing a reverse polarity across the corresponding FET, enabling the system 1 to keep functioning and to prevent damage to the controller 5 concerned. Indeed, these diodes 15 are typically not additional components, but are integrated by construction into the MOSFETs.

In order to measure parameters related to the cells 3 useful for diagnostics, each cell can be (but is not required to be) equipped with a corresponding temperature sensor 17 arranged to measure a temperature in the corresponding cell 3, and additional sensors 19, such as a cell pressure sensor arranged to measure the pressure in the corresponding cell 3, and/or a cell temperature sensor arranged to measure the temperature therein.

In order to be able to carry out measurements relating to the state of health (SOH), state of charge (SOC) and state of power (SOP) of each cell 3, each controller 5 is arranged to measure the voltage across the corresponding cell 3 (see the electrical connections marked "Voltage sensing"), by means of an analog-to-digital converter integrated with the controller 5 or external thereto, and is arranged to carry out galvanostatic electrochemical impedance spectroscopy (EIS), differential voltage analysis (DVA), galvanostatic intermittent titration technique (GITT), differential thermal voltammetry (DTV), or similar of the corresponding cell 3, alongside other diagnostics such as monitoring cell voltage. The specific case of EIS will be described in detail below, the modifications to use the other techniques being known to the skilled person.

In conventional EIS, an external excitation AC voltage at various predetermined frequencies is applied to a cell in equilibrium, causing it to absorb and discharge current. By measuring (or predetermining) this current and measuring the voltage across the cell, the impedance magnitude (magnitude of voltage divided by magnitude current) and impedance phase (the phase difference between the voltage signal and the current signal) is measured. The excitation current is typically relatively small, since relatively large currents are subject to significant nonlinearities. This allows studying the resistive, capacitive and inductive response of the cell 3 so as to reconstruct and model the underlying electrochemical processes such as (but not limited to): charge transfer resistance, double-layer capacitance, SEI (solid electrolyte interphase) layer growth and diffusion processes, as well as to determine SOH, SOC and SOP of the cell. See, for instance, D. I. Stroe, M. Swierczynski, A. I. Stan, V. Knap, R. Teodorescu and S. J. Andreasen, "Diagnosis of lithium-ion batteries state-of-health based on electrochemical impedance spectroscopy technique," 2014 IEEE Energy Conversion Congress and Exposition (ECCE), Pittsburgh, PA, 2014, pp. 4576-4582, doi: 10.1109/ECCE.2014.6954027.

Since an external excitation current is required, this is extremely costly and bulky to carry out in a battery system 1, since it requires a separate set of power connectors, separate controllers, etc, or at the very minimum a separate power source arranged to provide a higher voltage than that produced by the cell 3, such as a supercapacitor.

The architecture of the present invention avoids this, and enables carrying out EIS (or the other techniques mentioned) without external and/or extra power sources, cabling etc., and this is carried out while a cell 3 is bypassed.

To this end, each controller 5 is adapted to control a corresponding drain transistor 21 (a MOSFET in the illustrated embodiment) arranged in series with a corresponding resistor 23 so as to discharge the corresponding cell 3. The gate of the MOSFET is connected to an output of the corresponding controller 5 labelled "EIS excitation", and this output is modulated so as to cause a predetermined current to flow from the cell 3 through the corresponding resistor 23, this predetermined current being adapted to the electrochemical characteristics of the cell 3 in question. This current has a profile preferably comprising at least one sinusoid (which may be one or more sinusoids, a square wave, triangular wave or similar, which are composed of sinusoids as is well-known), and the frequency is varied to carry out EIS on the cell 3, with a frequency typically from 10 mHz to 10 kHz.

This can either be carried out digitally, e.g. by providing a pulse width modulated (PWM) signal at the EIS excitation output, or in an analogue fashion by low-pass filtering such a PWM signal to give an analogue sinusoid or combination of sinusoids. In this latter case, the low-pass filter can be internal to the controller 5, or external thereto and interposed between the EIS excitation output and the MOSFET 21, and the filter cut off should be higher than the highest frequency of interest.

As a result, the current drawn from the cell 3 varies from 0 to a minimum value which is small enough so retain sufficient linearity in the cell's response, typically below 1/20^{th} of the nominal charge rate of the cell 3 (i.e. <C/20 in conventional battery terminology). In doing so, the cell 3 will be slightly discharged, and the EIS is hence dissipative. This deviates from ordinary EIS testing practice, where the current oscillates between a positive and negative maximum value, with zero DC component. The drop in state of charge due to this slight discharge, however, is small enough not to influence the computation of the impedance, with a precision that is sufficient for most applications of interest. This drop in SOC can hence be neglected, and/or compensated for algorithmically, e.g. for frequencies lower than 1Hz. Since the current is a discharge current, its profile can be viewed as a sinusoid or combination of sinusoids superposed with a DC signal.

The exact details of the interrogation of the cell 3, particularly in respect of the frequencies used, are known in the art and need not be explained in detail here, as is the signal processing of the resulting data. Multiple frequencies superimposed can reduce the testing time.

In order to store the data obtained by the sensors 17, 19 and during the EIS (or other) process, and/or the imputation of the SOH and/or SOC and/or SOP of the individual cells 3 based thereupon (e.g. by means of various models, look-up tables, estimation algorithms such as filtering methods (e.g. Kalman filters, Extended Kalman filters, particle filters or similar) etc. as known in the literature), each controller 5 is associated with a corresponding local memory 25, which is either part of the controller 5 itself or is proximate thereto and packaged therewith. As a result, each controller 3 has its own memory 5, meaning that, if a battery system 1 is split up for a second-life application (e.g. cells 3 used in a car battery being repurposed for use in a storage battery for a photovoltaic system), each packaged cell retains information about its condition, which can be accessed. As a result, cells 3 which still have good remaining life can be re-used, whereas those in poor condition can be excluded and sent for recycling or disposal.

In order to enable the various controllers 5 to communicate and coordinate their operation, each is associated with a communications interface 27. In the illustrated embodiment, this communications interface 27 comprises a transponder coil connected with the controller at the ports marked "PLC", and arranged so as to transmit and receive signals via powerline communication, using the powerline 7 for transmission of data, with the controllers 5 hence being networked to each other. Alternatively, wireless communication such as via Bluetooth, WiFi, infrared or similar can be used.

Coordination between the various controllers 5 can be carried out by distributed processing, i.e. the controllers 5 coordinating among themselves, or one controller 5 can be designated as Master Controller, which then gives commands to the other controllers 5, and also receives signals therefrom. Another alternative is that a central master controller 33 which is not associated with any one cell 3 in particular communicates with and commands all the controllers 5, as illustrated by the dotted box marked "CTRL".

As illustrated by the dashed boxes, each cell 3, corresponding controller 5 and corresponding associated components (9, 17, 19, 21, 23, 25, 27 and subcomponents thereof), can be packaged as a cell package 29, which can then be assembled into a modular battery system 1 according to the invention, the external powerline 7 interconnections being made between electrical connection terminals 31 (input), 32 (output) passing through a suitable casing provided so as to support the various elements of each cell module 29 together. This particularly assists with repurposing the individual cell modules 29 for second-life applications.

Furthermore, the only external wiring required is the interconnecting parts the powerline 7, connecting the various terminals 31, 32 in series, since each cell module 29 is entirely self-contained, and can carry out EIS without any external source of power.

As a result, if an individual cell 3 requires replacement, its cell package 29 can simply be replaced.

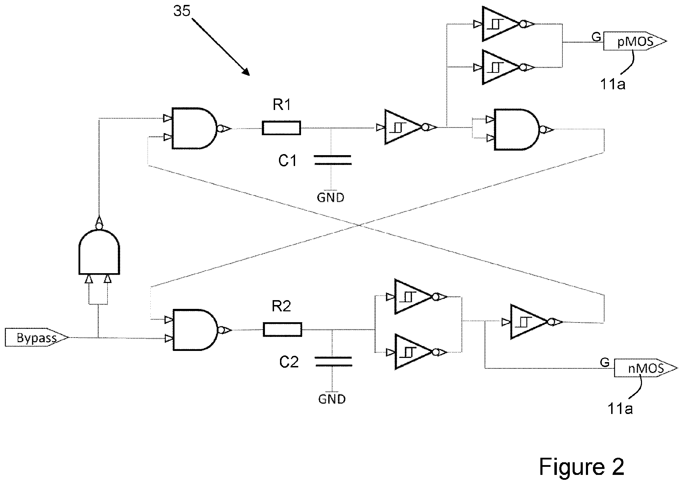

Figure 2 illustrates an optional switching circuit 35 which can be included between the bypass terminal of each controller 5 and the corresponding MOSFETS 11, 13 of the corresponding bypass circuit 9. On this figure, the reference signs from the lower module 29a of figure 1 have been used for illustrative purposes, and the same circuit can self-evidently be applied to all of the modules 29.

In essence, with a direct connection between the bypass terminal and the MOSFETs 11, 13, in case of malfunction there is a risk that both MOSFETS can conduct at the same time, notably if the MOSFET which is switching into its conductive state changes state faster than the MOSFET which is switching into its non-conductive state. In such a situation, the corresponding cell 3 is short circuited, and can discharge rapidly through the corresponding MOSFETs 11, 13, thereby damaging them, and presenting a risk of further damage, fire etc.

The switching circuit 35 of figure 2 avoids this, by introducing a delay between one MOSFET becoming non-conducting and the other becoming conducting, so as to prevent any situation where both are simultaneously conducting.

The switching circuit 35 itself is self-explanatory from the circuit diagram, the RC circuits and the logic gates ensuring that when "bypass" changes from 0 to 1 or vice-versa, there is a time lag between the gates G of the MOSFETS 11, 13 changing state, the change in the one which moves the corresponding MOSFET 11a, 13a into a non-conductive state taking place before the change in the one which moves the corresponding MOSFET 13a, 11a into a conductive state. This time lag can be tuned by varying the values of the resistors R1, R2 and the capacitors C1, C2, the greater the time coefficient of each RC pair, the longer the time lag.

Other time delay circuits achieving the same end are naturally possible, and that which is illustrated is not to be construed as limiting, however it is extremely simple to construct.

The architecture of the battery system 1 having now been described, methods of operation will can be carried out be discussed below.

In normal operation, at any given time, at least one cell 3 is bypassed for a predetermined time period (which may be minutes or hours, or even longer periods under certain circumstances), the number bypassed depending on the difference between the sum of nominal voltages of all the cells 3 in a string and the output voltage of the string. Typically, this will only be one, but it may also be two or more. In the following description it will be assumed that only one cell 3 is bypassed at any given time, and modifications of the method to handle multiple bypassed cells are within the reach of the skilled person.

During the time that the cell 3 is bypassed, diagnostics are carried out, which may include measuring the cell voltage, dissipative EIS or other diagnostics as mentioned above. Data relating to these diagnostics are stored in the memory 25 associated with the cell 3 in question, and are typically transmitted via the corresponding communication interface 27 to the other controllers 5, such that the data can be acted upon, whether by distributed processing, a master controller 5 or by an external controller.

The cell 3 in question can then be re-connected to the string, while a different cell 3 is bypassed and diagnostics are carried out thereupon, data related thereto being stored in the memory 25 packaged with each cell 3.

Once sufficient data has been gathered about the state of all the cells 3 in a given string, this can be acted upon in order to optimise the performance and/or lifetime of the battery system 1.

For instance, the SOC of the cells 3 of a given string can be balanced by varying the timings that the individual cells 3 are bypassed. For instance, cells 3 with a lower SOC can be bypassed for longer than cells 3 with a higher SOC, e.g. by pausing for a given period before or after carrying out diagnostics. This results in the higher SOC cells 3 being discharged faster.

In a similar manner, the SOH of the cells 3 can be balanced, in order to maximise the lifetime of the battery system 1. Since the performance of any given string of cells 3 is determined by the weakest cell 3, on the basis of the determined SOH, weaker cells can be bypassed for longer than stronger cells, e.g. by pausing for a given period before or after carrying out diagnostics. This results in the higher SOH cells 3 being used to a greater degree than the lower SOH cells 3. In this case, the bypassing of cells 3 can for instance be modulated on the basis of the value of impedance at a given frequency or combination of frequencies, or other indicators extrapolated from the processing of impedance data (e.g. SOH). The greater the difference between the present value of this impedance and the initial value when the cell 3 in question is new (as stored in the corresponding memory 25), the longer the relative time that the cell 3 is bypassed. Moreover, if a cell 3 incurs a fault (e.g. internal short circuit), this cell 3 can be promptly bypassed to ensure the safe continued operation of the battery system 1.

In all cases, the diagnostics and bypassing can be carried out irrespective of whether the string of cells 3 is supplying current or is being charged. Furthermore, if the string of cells 3 is at rest, i.e. is not being charged or discharged, diagnostics can be carried out on one or more individual cells 3 therein without them being bypassed.

Furthermore, in a case in which an individual cell 3 has been over-charged compared to the other cells in the string, the corresponding MOSFET 21 can be controlled by the corresponding controller so as to dissipate excess power through the corresponding resistor 23 so as to bring the SOC of the cell 3 in question down rapidly.

Although the invention has been described with reference to specific embodiments, variations thereto are possible without departing from the scope of protection as defined by the appended claims.

## Claims

1. Battery system (1) comprising a plurality of rechargeable cells (3) connectable in series along a power line (7), each cell (3) being packaged with:
- a corresponding controller (5);
- a corresponding memory (25);
- a corresponding communications interface (27);
wherein each cell (3) is arranged to be bypassable under the control of said corresponding controller (5), said corresponding controller (5) being adapted to:
- bypass the corresponding cell (3) by means of a corresponding bypass circuit (9);
- carry out diagnostics on said corresponding cell (3) when bypassed, under the power of said corresponding cell (3);
- communicate with at least one other controller (5; 33) by means of said corresponding communications interface (27), and
- store information relating to said diagnostics in said corresponding memory (25).

2. Battery system (1) according to the preceding claim, further comprising a central controller (33) adapted to coordinate the operation of said corresponding controllers (5) and in communication with said corresponding controllers (5).

3. Battery system (1) according to claim 1, arranged such that one controller (5) packaged with a cell (3) in said battery system acts as master controller to coordinate the operation of said corresponding controllers, or such that corresponding controllers (5) are arranged to coordinate the operation of said corresponding controllers (5) by distributed processing.

4. Battery system (1) according to the preceding claim, wherein said corresponding communications interface (27) is adapted to communicate with said at least one other controller (5; 33) via at least one of:
- powerline communication;
- infrared communication;
- wireless communication.

5. Battery system (1) according to any preceding claim, wherein said corresponding bypass circuit (9) comprises a first transistor (11) and a second transistor (13) arranged to direct current from a first connection terminal (31) to said corresponding cell (3) or to a second connection terminal (32) under the control of said corresponding controller (5) depending on an output (Bypass) of said corresponding controller (5).

6. Battery system (1) according to claim 5, wherein said corresponding bypass circuit (9) further comprises a switching circuit (35) arranged such that, when said output (Bypass) of said corresponding controller (5) changes state, said transistor (11, 13) which is in a conducting state is switched to a non-conducting state prior to the transistor (13, 11) which is in a non-conducting state being switched to a conducting state.

7. Battery system (1) according to any preceding claim, further comprising a drain transistor (21) in series with a resistor (23) so as to form a circuit with said corresponding cell (5), said drain transistor (21) being controllable by said corresponding controller (5) so as to drain current from said corresponding cell (3) in order to carry out diagnostics thereupon.

8. Battery system (1) according to any preceding claim, wherein said corresponding controller (5) is arranged to measure a voltage across said corresponding cell (3).

9. Battery system (1) according to any preceding claim, further comprising at least one sensor (17, 19) arranged to measure a parameter of said corresponding cell (3) such as its temperature or pressure.

10. Method of operation of a battery system (1) according to any preceding claim, comprising steps of:
- bypassing at least one predetermined cell (3);
- carrying out diagnostics on said predetermined cell (3) by means of said corresponding controller (5);
- storing information relating to said diagnostics in said corresponding controller (25);
- communicating said information relating to said diagnostics to at least one other controller (5; 33);
- coordinating said cell (3) bypassing to optimise at least one of battery system lifetime and charge balancing between said cells.

11. Method according to claim 10, wherein said diagnostics are carried out at least partially by means of an electrochemical impedance spectroscopy method, a differential voltage analysis method, differential thermal voltammetry, or a galvanostatic intermittent titration technique.

12. Method according to claim 11, wherein said battery system (1) is according to claims 7 and 8, the corresponding controller (5) controlling said drain transistor (21) in order to drain current from said predetermined cell (3) with a current profile having at least one predetermined frequency, while measuring a voltage across said corresponding cell (3).

13. Method according to one of claims claim 10-12, wherein said coordination is carried out by one of:
- a central controller (33);
- a controller (5) corresponding to a given cell (3);
- by a plurality of said controllers (5) corresponding to said cells (3), by distributed processing.

14. Method according to one of claims 10-13, further comprising optimising of at least one of state of health, state of charge and state of power of said cells (3) by bypassing certain cells (3) for relatively longer times than others in function of the state of health and/or state of charge and/or state of power of said cells (3).

15. Method according to one of claims 10-14, wherein said battery system (1) is according to claim 7, and wherein, if a particular cell (3) is determined as having an excessively high state of charge, the corresponding drain transistor (21) is controlled by the corresponding controller in order to reduce its state of charge.
